# EUROPEAN PATENT SPECIFICATION

(11) **EP 0 542 254 B1**
(45) Date of publication and mention of the grant of the patent: **21.03.2001**
(21) Application number: 92119352.0
(22) Date of filing: 12.11.1992
(51) Int. Cl.: G03F 7/32

(54) **Method and developer for the development of flexographic printing plates**
Verfahren und Entwickler zum Entwickeln von Flexodruckplatten
Procédé et développeur pour le développement de plaques d'impression flexographiques

(30) Priority: 12.11.1991 JP 32241691
(43) Date of publication of application: 19.05.1993
(73) Proprietor: TOKYO OHKA KOGYO CO., LTD., Kawasaki-shi Kanagawa-ken (JP)
(72) Inventor: Takagi, Toshiya, Fujisawa-shi, Kanagawa-ken (JP); Aoyama, Toshimi, Fujisawa-shi, Kanagawa-ken (JP); Ohta, Katsuyuki, Atsugi-shi, Kanagawa-ken (JP)
(74) Representative: Beetz & Partner Patentanwälte

(56) References cited:
- EP-A- 0 332 070
- EP-A- 0 365 988

## Description

The present invention relates to an improvement in the method for the development of flexographic printing plates in photolithographic patterning processes. More particularly, the invention relates to an improved method and liquid developer for the development of flexographic printing plates after pattern-wise exposure to light in a photolithographic patterning process, leading to the advantages of high fidelity of patterning and the absence of problems relative to safety and environmental pollution.

Flexographic printing is a kind of letterpress printing process using a relief printing plate which is prepared from a layer of a photosensitive resin composition having rubber elasticity on a substrate plate by exposure to light through a transparent negative to cure the composition followed by development with a suitable liquid developer capable of dissolving away the resin layer on the unexposed areas. Various types of photosensitive resin compositions are known in the prior art as materials for the preparation of flexographic printing plates, many of them consist of a thermoplastic elastomer, a photopolymerizable ethylenically unsaturated monomeric compound and a photopolymerization initiator (see, for example, JP-51-43374 and JP-59-22219).

In the preparation of flexographic printing plates by using a photosensitive resin composition as mentioned above, a layer of the photosensitive resin composition formed on the surface of a substrate is exposed pattern-wise to actinic rays such as ultraviolet light through a transparent negative to insolubilize the resin composition on the exposed areas, followed by a development treatment of the plate by using a liquid developer which is capable of dissolving away or swelling the uncured resin composition on the unexposed areas. Various kinds of organic solvents or mixtures thereof are known and used in the prior art as developers in the above-described photolithographic preparation of flexographic printing plates, including halogenated hydrocarbon solvents such as chloroform, trichloroethane, trichloroethylene, tetrachloroethylene and the like and mixtures thereof, optionally with admixture of an alcoholic solvent.

These known liquid developers, however, are disadvantageous because they not only dissolve away the resin layer on the unexposed areas but also lead to a swelling of the resin layer in the exposed areas, which badly affects the fidelity of the relief pattern relative to the pattern of the transparent negative. Moreover, halogenated hydrocarbon solvents are known for their toxicity to human, and for causing serious problems of pollution of the atmosphere and of the working environment.

Alternatively, JP-2-267557 proposes a method for the development of flexographic printing plates by using an oil-in-water type aqueous emulsion of an organic solvent mixture mainly consisting of a chlorinated hydrocarbon solvent, a saturated or unsaturated non-cyclic hydrocarbon solvent, a petroleum distillate, and hydrogenated petroleum. Developers of this type, however, cannot provide a complete solution for the problem of environmental pollution in the prior art methods, again due to the use of a chlorinated hydrocarbon solvent, an additional disadvantage being the unduly long development time which causes a low productivity of the development process.

EP-A-0 365 988 discloses a developer solvent and a method of developing flexographic printing plates. The essential component of the developer solvent is an aromatic compound; it is described that additional components may be present, however, only alcohols, particularly alcohols having a higher boiling point, are disclosed as additional developer components.

EP 0 332 070 describes developer solvents for printing plates which are hydrogenated petroleum fractions which may contain 0.5 to 50 % of naphthenic hydrocarbons. It is expressly stated in this document that the hydrogenated petroleum fractions as used have a content of aromatic hydrocarbons of less than 1 %.

Therefore, these two prior art documents cannot be considered in combination because EP-A-0 365 988 teaches the use of aromatic developer solvents which, on the other hand, are excluded in EP 0 332 070.

Accordingly, the underlying problem of the present invention is to provide an improved method for the development of flexographic printing plates after pattern-wise exposure to light by using a specific liquid developer and a suitable developer, allowing to achieve high fidelity of patterning, and to avoid problems of environmental pollution due to developer toxicity.

The above problem is solved according to the independent claims. The dependent claims relate to preferred embodiments.

The method of the present invention of developing flexographic printing plates having a layer of a photosensitive resin composition exhibiting rubber elasticity on a substrate after pattern-wise exposure of the layer to actinic rays by using a liquid developer which comprises
(a) 30 to 80 % by mass of one or more aromatic hydrocarbon compounds having a boiling point of 90 to 300 °C, is characterized in that the developer further comprises
(b) from 20 to 70 % by mass of one or more paraffinic and/or naphthenic hydrocarbon compounds having a boiling point of 90 to 300 °C,
the sum of the amounts of (a) and (b) being 100 % by mass.

In accordance therewith, the developer of the present invention comprises the components (a) and (b) as specified above.

As described above, the improvement according to the present invention is achieved by using a specific mixture of two types of hydrocarbon solvents (a) and (b) in the specified weight proportions as liquid developer.

The flexographic printing plate as the objective of the development according to the invention has a layer of a photosensitive resin composition formed on the surface of a substrate plate. The photosensitive resin composition mentioned above typically comprises a thermoplastic elastomer, a photopolymerizable ethylenically unsaturated monomeric compound and a photopolymerization initiator.

The thermoplastic elastomer here implied is a polymeric material exhibiting mechanical properties similar to those of a vulcanized rubber at room temperature but plasticity similar to that of a conventional thermoplastic resin at elevated temperatures. A great variety of thermoplastic elastomers are known in the prior art as ingredients in the photosensitive resin compositions for flexographic printing plates, including elastomers on the basis of polystyrene, polyolefins, polyesters, polyurethanes, polyisoprenes, 1,2-polybutadienes, polyvinyl chloride, polyamides, and the like, of which polystyrene-based elastomers are particularly preferable. Particular examples of suitable polystyrene-based thermoplastic elastomers include styrene-butadiene-styrene block copolymers and styrene-isoprene-styrene block copolymers as well as hydrogenation products thereof.

The amount of the thermoplastic elastomer in the photosensitive resin compositions for flexographic printing plates is in the range of 30 to 95 % by mass or, preferably, of 50 to 85 % by mass. When the amount thereof in the composition is too small, the layer of the composition would be poor in the rubber elasticity while, when the amount of the thermoplastic elastomer in the composition is too large, the fidelity of patterning of the printing plate would be decreased.

The photopolymerizable ethylenically unsaturated monomeric compound is not particularly limited to compounds of a specific type provided that the monomers have good compatibility or miscibility with the above-mentioned thermoplastic elastomers. The monomeric compound should have one or more ethylenically unsaturated linkages susceptible to photopolymerization in the molecule. Particular examples of suitable photopolymerizable monomers include diesters derived from aliphatic or alicyclic diols having 2 to 10 or, in particular, 2 to 6 carbon atoms in the molecule, e.g., ethylene glycol, triethylene glycol, hexane diol, cyclohexane diol and the like, and ethylenically unsaturated carboxylic acids having 3 to 5 carbon atoms in the molecule, e.g., acrylic acid, methacrylic acid and the like, triesters derived from a triol, e.g., trimethylol propane, and ethylenically unsaturated carboxylic acids as mentioned above, vinyl esters of a polybasic carboxylic acid, and so on. These photopolymerizable monomers can be used either alone or in combination of two kinds or more, according to need.

The amount of these photopolymerizable monomers in the photosensitive resin composition is in the range of 3 to 80 parts by mass or, preferably, 5 to 20 parts by mass, per 100 parts by mass of the thermoplastic elastomer. When the amount thereof is too small, fidelity in the patterning of the printing plate would be decreased while, when the amount thereof is too large, the layer of the photosensitive resin composition would be poor in rubber elasticity.

Various types of photopolymerization initiator compounds are known in the prior art to effect photopolymerization of the above mentioned photopolymerizable monomers, and any of them can be used in the photosensitive resin composition for flexographic printing plates. Particularly preferable, however, are benzoin compounds, benzophenone compounds and anthraquinone compounds, which can be used either alone or in combination of two kinds or more, according to need.

The amount of the photopolymerization initiator in the photosensitive resin composition is in the range of 0.1 to 5 parts by mass or, preferably, 0.5 to 2 parts by mass, per 100 parts by mass of the thermoplastic elastomer. When the amount thereof is too small, the photosensitivity of the composition would be too low so that the composition cannot be used in practical applications while, when the amount thereof is too large, the quality of patterning of the printing plate would be somewhat decreased.

It is of course optional that the photosensitive resin composition, of which the essential ingredients are the above-described three components, may be further admixed, according to need, with various kinds of known additives including thermal polymerization inhibitors such as cresol compounds, phenolic compounds, hydroquinone compounds and the like, synthetic resins, pigments, dyes, plasticizers, antioxidants, photodegradation retarders and the like, each in a limited amount.

The photosensitive resin composition prepared from the above-described essential and optional ingredients can be shaped into the form of a film or plate which serves as the photosensitive resin layer of a flexographic printing plate. For example, an organic solution prepared by dissolving the ingredients is shaped by casting followed by evaporation of the solvent into the form of a film or a plate. Alternatively, the ingredients are mixed together without using an organic solvent on a suitable mixing machine such as roller mills into a uniform composition which is shaped into the form of a film or plate by compression molding in a hot press. The thus obtained films or plates of the photosensitive resin composition are then press-bonded to a substrate plate such as a polyester plate, steel plate, aluminum plate and the like, to give flexographic plates which can be patterned into a printing relief having rubber elasticity by a photolithographic process. Namely, the layer of the photosensitive resin composition is exposed to actinic rays, e.g., ultraviolet light, pattern-wise through a transparent negative so as to cure the resin composition in the exposed areas, followed by development with a liquid developer which dissolves away the resin composition in the unexposed areas leaving the cured resin composition having rubber elasticity in the exposed areas.

The improvement according to the present invention concerns the above described development process and developer; it can be achieved by using a specific solvent mixture as the liquid developer comprising the components (a) and (b) in the specified mixing proportions and having a power of dissolving or swelling the uncured photosensitive resin composition.

The component (a) in the liquid developer according to the invention is an aromatic hydrocarbon compound having the specified boiling point in the range of 90 to 300 °C; examples therefor are toluene, xylene, methylethylbenzene, propylbenzene, trimethylbenzene, tetramethylbenzene, diethylbenzene, dimethylethylbenzene, naphthalene, methylnaphthalene, and the like. These aromatic hydrocarbon compounds can be used as the component (a) either alone or as a combination of two kinds or more, according to need. In particular, various grades of commercial solvent products are available on the market, the constituents of which include the above-defined aromatic hydrocarbon compounds. These commercial solvent products can be used as such as component (a) provided that the constituents thereof meet the above given definition of component (a). Examples of such commercial aromatic solvent products include Solvesso 100, 150 and 200 (trade names of products by Exxon Chemical Co.), Swasol 100, 200, 310, 1000, 1500 and 1800 (trade names of products by Maruzen Petrochemical Co.).

It is essential that the aromatic hydrocarbon compound as the component (a) has a boiling point of 90 to 300 °C or, preferably, of 130 to 200 °C. When the boiling point thereof is too low, the vaporizability of the liquid developer would be increased so as to increase the loss thereof by dissipation into the atmosphere along with an increased danger of fire. When the boiling point thereof is too high, on the other hand, the disadvantage is caused that an unduly long time is necessary for drying the flexographic printing plate after development using the liquid developer though with a decreased danger of fire as a consequence of the increased flash point.

The component (b) used in combination with the above described component (a) is, on the one hand, a paraffinic hydrocarbon compound or, on the other hand, a naphthenic hydrocarbon compound having a boiling point of 90 to 300 °C. The paraffinic hydrocarbon compound having a boiling point in the above-mentioned range is exemplified by heptane, octane, nonane, methyloctane, decane, undecane, dodecane, tridecane, and the like. These paraffinic hydrocarbon compounds can be used either alone or in combination of two kinds or more, according to need. In particular, various grades of commercial solvent products are available on the market, the constituents of which include the above-defined paraffinic hydrocarbon compounds. These commercial solvent products can be used as such as the component (b) provided that the constituents thereof meet the above given definition of component (b). Examples of such commercial paraffinic solvent products include Isopar C, E, G, H and L (trade names of products by Exxon Chemical Co.).

It is essential that the paraffinic hydrocarbon compound as the component (b) has a boiling point of 90 to 300 °C or, preferably, of 150 to 250 °C. When the boiling point thereof is too low, the vaporizability of the liquid developer would be increased so as to cause human health problems and environmental pollution by increased dissipation thereof into the atmosphere along with an increased danger of fire. When the boiling point thereof is too high, on the other hand, the disadvantage is caused, similarly to the aromatic hydrocarbon compounds as component (a), that an unduly long time is necessary for drying the flexographic printing plates after development with the liquid developer.

The component (b) can alternatively be a naphthenic or cycloparaffinic hydrocarbon compound having a boiling point of 90 to 300 °C, which is exemplified by dimethylcyclohexane, methylethylcyclohexane, propylcyclohexane, trimethylcyclohexane, butylcyclohexane, decahydronaphthalene, methyldecahydronaphthalene and the like. These naphthenic hydrocarbon compounds can be used either alone or as a combination of two kinds or more, according to need. In particular, various grades of commercial solvent products are available on the market, the constituents of which include the above-defined naphthenic hydrocarbon compounds. These commercial solvent products can be used as such as the component (b) provided that the constituents thereof meet the above given definition of component (b). Examples of such a commercial naphthenic solvent product include Naphthezol L, M and H (trade names of products by Nippon Petrochemical Co.).

It is essential that the naphthenic hydrocarbon compound as the component (b) has a boiling point of 90 to 300 °C or, preferably, from 150 to 270 °C. The disadvantages caused when the boiling point of the naphthenic hydrocarbon compound is too low or too high are the same as those when the boiling point of the paraffinic hydrocarbon compound is too low or too high.

The component (b), which is combined with the component (a) to form the liquid developer used according to the invention, can be either the paraffinic hydrocarbon compound or the naphthenic hydrocarbon compound, each within the above given definition. It is of course optional that the component (b) is a combination of a paraffinic hydrocarbon compound and a naphthenic hydrocarbon compound, if desired. It is noted, however, that the use of a naphthenic hydrocarbon compound alone as the component (b) is less preferable than the use of a paraffinic hydrocarbon compound alone or a combination of the two types of hydrocarbon compounds.

The aromatic hydrocarbon solvent as the component (a) in the developer is generally a good solvent for dissolving the thermoplastic elastomer in the photosensitive resin composition while the paraffinic hydrocarbon compound of the component (b), though without a dissolving power for the thermoplastic elastomer, serves to control the treatment time of development and to suppress swelling of the photosensitive resin composition cured by exposure to light. It is noteworthy that paraffinic hydrocarbon compounds generally have lower toxicity to human than aromatic hydrocarbon compounds. Although the naphthenic hydrocarbon compounds can dissolve the thermoplastic elastomer, the dissolving power therefor is lower than that of the aromatic hydrocarbon compounds so that swelling of the cured photosensitive resin composition can also be reduced by the admixture thereof.

The liquid developer according to the invention for the development of flexographic printing plates consists necessarily of 30 to 80 % by mass or, preferably, of 50 to 80 % by mass of the component (a), i.e., the aromatic hydrocarbon compound, and of 70 to 20 % by mass or, preferably, of 50 to 20 % by mass of the component (b), i.e., the paraffinic and/or naphthenic hydrocarbon compounds. When the content of the component (a) is too small, a somewhat increased time is necessary for the development of a flexographic printing plate, leading to a decrease of the productivity of the development process. When the content of the component (a) is too large, on the other hand, the quality of the patterned printing plate would be poor in addition to the human health problems and the problems of environmental pollution due to the increased toxicity of the developer. It is a matter of course that a commercial solvent product alone can be used as such as the developer according to the invention in the development treatment of flexographic printing plates, provided that the solvent product contains both the aromatic and paraffinic and/or naphthenic hydrocarbon compounds, each within the definition of the components (a) or (b) in the above-specified mass proportions.

It is sometimes advantageous that the liquid developer consisting of the above-described components (a) and (b) is further admixed with (c) an alcoholic compound in such a proportion that the content of the alcoholic compound is 1 to 30 % by mass, based on the total mass of the developer. Examples of suitable alcoholic compounds include n-butanol, n-pentanol, n-hexanol, 3-methyl-3-methoxybutanol, benzyl alcohol, and the like.

The admixture of an alcoholic compound to the developer has the effect to suppress swelling of the photosensitive resin composition cured by exposure to light. Further, an additional advantage is obtained by the addition of an alcohol to the developer when the flexographic printing plate under development is, as is the case in most of the commercial products of flexographic plates, provided on the surface with an anti-sticking coating layer of, for example, a polyamide resin, with the object to temporarily protect the plate from troubles due to inadvertent sticking because the liquid developer can be imparted with an increased dissolving power for such an anti-sticking coating layer by the admixture of an alcohol.

When the development treatment of a flexographic printing plate is conducted according to the invention by using the present liquid developer as described above in detail, a relief printing plate having a very high quality can be obtained with enhanced productivity due to the shortened time necessary for development and subsequent drying. In addition, a great improvement can be obtained according to the invention in respect of the safety and human health problems as compared with the prior art development treatment by using conventional developers.

In the following, the invention is described in more detail by way of examples. The indicated parts and concentrations given in percent are on mass basis.

### Example 1

A uniform photosensitive resin composition was prepared by heating, for 2 hours under reflux with agitation, a mixture in a flask consisting of 200 parts of methyl ethyl ketone, 100 parts of a thermoplastic elastomer which was a styrene-butadiene-styrene block copolymer containing 28 % of styrene moieties and having a mass-average molecular mass of 130 000 (TRKX 65S, a product by Shell Chemical Co.), 60 parts of a liquid polybutadiene containing 85 % or more of 1,2-butadiene moieties and having a mass-average molecular mass of 1050 (NISSO-PB B-1000, a product by Nippon Soda Co.), 6 parts of trimethylolpropane triacrylate, 2 parts of benzyl methyl ketal and 0.012 part of 2,6-di-tert-butyl-4-methylphenol. This photosensitive resin composition was applied to the surface of a film of polyethylene terephthalate (PET) resin having a thickness of 100 µm provided with an adhesive layer in a coating amount to give a film of 2.74 mm in thickness after drying followed by drying at 60 °C for 12 hours.

Separately, another PET resin film of 100 µm in thickness was coated from a solution prepared by dissolving 5 g of an alcohol-soluble polyamide resin (Macromelt 6900, a product by Henkel Co.) in 100 g of methanol in a coating thickness of 5 µm as dried, followed by drying at 60 °C for 2 minutes. This polyamide resin film supported on a PET film was put on the surface of the layer of the photosensitive resin composition supported on the first PET resin film as the substrate and laminated therewith by pressing.

The layer of the photosensitive resin composition was then exposed to ultraviolet light over the whole surface through the substrate, i.e., the first PET resin film, by using a chemical lamp (Model FL-40BL, a product by Toshiba Corp.) for two minutes and, after removal of the second PET resin film on the polyamide resin layer by peeling, further exposed to light using the same chemical lamp as above for 15 minutes through a transparent negative of test chart pattern put on and in direct contact with the polyamide resin layer by pressure reduction.

Further, separately, a developer mixture was prepared from 4 kg of a commercial aromatic solvent product having a boiling point of 188 to 210 °C (Solvesso 150, supra), 4 kg of a commercial solvent product consisting of 60 % of naphthenic hydrocarbon compounds and 40 % of paraffinic hydrocarbon compounds and having a boiling point of 177 to 200 °C (Naphthezol L, supra) and 1 kg of benzyl alcohol.

The flexographic plate obtained after the pattern-wise exposure to light as described above was subjected to a development treatment by using this developer mixture at 25 °C for 5 minutes in a brushing-type developer machine, dried by heating at 50 °C for 30 minutes and then subjected to a whole-surface exposure to light for 15 minutes by using the same chemical lamp as above to give a flexographic relief-printing plate.

The thus prepared flexographic relief-printing plate was inspected for evaluation to find that 2 % of the highlight portion could be excellently reproduced for 65 lines/inch mesh points, and the minimum reproducible width of an isolated line was 200 µm. The quality of the relief pattern was excellent without any noticeable scratches or chipping-off on the surface of the patterned relief and the shoulder portion of the relief caused by brushing.

### Comparative Example 1

The experimental procedure for the development of a flexographic printing plate was substantially the same as in Example 1, except for the use of a developer which was a mixture of 9 kg of 1,1,1-trichloroethane and 1 kg of n-butanol. It was noted in the course of the development and drying of the plate that very intense unpleasant odors of the chlorinated hydrocarbon solvent were formed, leading to human health and environmental problems. Inspection of the printing plate for evaluation gave the result that the highlight reproduction was 3 % for 65 lines/inch mesh points, and the minimum reproducible width of an isolated line was 300 µm. In addition thereto, the problem of considerable swelling of the resin composition on the areas exposed to light occured.

### Comparative Example 2

The experimental procedure for the development of a flexographic printing plate was substantially the same as in Example 1, except for the use of a developer which was a mixture of 8 kg of Solvesso 150 (supra) and 1 kg of benzyl alcohol. Inspection of the printing plate for evaluation gave the result that the highlight reproduction was 5 % for 65 lines/inch mesh points, and the minimum reproducible width of an isolated line was 400 µm. In addition thereto, the problem of scratches and chipping-off caused by brushing on the surface and shoulder portions of the patterned relief occured.

### Comparative Example 3

The experimental procedure for the development of a flexographic printing plate was substantially the same as in Example 1, except for the use of a developer which was a mixture of 8 kg of Naphthezol L (supra) and 1 kg of benzyl alcohol, and extension of the development time to 10 minutes because of the incomplete development after 5 minutes of development treatment. Inspection of the thus prepared printing plate for evaluation gave the result that the highlight reproduction was 5 % for 65 lines/inch mesh points, and the minimum reproducible width of an isolated line was 400 µm although the printing plate could hardly be used in practical printing due to the problem of very heavy scratches and chipping-off caused by brushing on the surface and shoulder portions of the patterned relief.

### Comparative Example 4

The experimental procedure for the development of a flexographic printing plate was substantially the same as in Example 1, except for the use of a developer which was an emulsion of a mixture consisting of 24 liters of a commercial solvent product having a boiling point of 186 to 217 °C and containing 35 % of naphthenic hydrocarbon compounds and 65 % of paraffinic hydrocarbon compounds (Exzol D, a product by Exxon Chemical Co.), 6 liters of n-butanol and 30 liters of water, according to the disclosure in Example 1 of JP-2-267557. It was found that the development time must be extended to 15 minutes for complete development. The thus prepared printing plate was found to be defective due to the very heavy scratches on the surface and shoulder portions of the patterned relief as well as chipping-off of isolated lines in many portions as a consequence of the development treatment continued for such a long time.

### Example 2

The experimental procedure for the development of a flexographic printing plate was substantially the same as in Example 1 except that the developer used here was a mixture of 6 kg of a commercial hydrocarbon solvent product having a boiling point of 153 to 179 °C and containing 50 % of aromatic hydrocarbon compounds and 50 % of paraffinic hydrocarbon compounds (Swasol 310, supra), 2 kg of a commercial paraffinic hydrocarbon solvent product having a boiling point of 176 to 192 °C (Isopar H, supra) and 1 kg of 3-methyl-3-methoxybutanol. The results were quite as satisfactory as in Example 1.

### Example 3

The experimental procedure for the development of a flexographic printing plate was substantially the same as in Example 1 except that the developer used here was a mixture of 6 kg of a commercial product of aromatic hydrocarbon solvents having a boiling point of 231 to 275 °C (Solvesso 200, supra), 2 kg of a commercial hydrocarbon solvent product having a boiling point of 213 to 232 °C and containing 60 % of naphthenic hydrocarbon compounds and 40 % of paraffinic hydrocarbon compounds (Naphthezol M, supra) and 1 kg of benzyl alcohol.

Although the developer of this composition was highly safe regarding the danger of fire because of its high flash point of 96 °C, a problem in the use thereof was the relatively low velocity of drying so that the printing plate after 30 minutes of drying at 50 °C still had a thickness of 2.95 mm indicating incomplete drying of the plate which could be completely dried only by extending the drying time to 45 minutes to give a flexographic relief-printing plate having a quality as satisfactory as in Example 1.

### Example 4

A photosensitive resin composition was prepared from 100 parts of a thermoplastic elastomer (TRKX 1107, a product by Shell Chemical Co.) which was a styrene-butadiene-styrene block copolymer having a mass average molecular mass of 210 000 and containing 14 % of styrene moieties, 50 parts of the same liquid polybutadiene as used in Example 1, 6 parts of hexanediol diacrylate, 2 parts of benzyl dimethyl ketal and 0.1 part of 2,6-di-tert-butyl-p-cresol dissolved in 200 parts of methyl ethyl ketone. A PET resin film having a thickness of 100 µm provided on one surface with a coating layer of an adhesive was coated with the above prepared photosensitive resin composition in such a coating amount that the thickness of the coating layer as dried was 2.44 mm, followed by drying at 60 °C for 12 hours.

The layer of the photosensitive resin composition was exposed to ultraviolet light for 2 minutes over the whole surface through the PET resin film by using the same chemical lamp as used in Example 1, and a transparent negative was put on the surface of the layer of the photosensitive resin composition in direct contact therewith by pressing with a roller. The photosensitive layer was exposed pattern-wise to ultraviolet light through the transparent negative for 15 minutes using the chemical lamp.

The development treatment of the photosensitive layer after the pattern-wise exposure was conducted by using a developer which was a mixture of Swasol 310 (supra) and Naphthezol L (supra) in a mass ratio of 6:4, followed by drying and post-exposure treatment in the same manner as in Example 1 to give a flexographic relief-printing plate.

The thus prepared printing plate was inspected for evaluation to give the results that the highlight reproduction was 2 % for 65 lines/inch mesh points, and the minimum reproducible width of an isolated line was 200 µm, which was as satisfactory as in Example 1.

### Example 5

The experimental procedure was just the same as in Example 1 except that the developer was a mixture of 6 kg of Swasol 310 (supra) and 1 kg of 3-methyl-3-methoxybutanol.

The results of the inspection for evaluation of the thus prepared flexographic relief-printing plate were as satisfactory as in Example 1.

## Claims

1. Method of developing flexographic printing plates having a layer of a photosensitive resin composition exhibiting rubber elasticity on a substrate after pattern-wise exposure of the layer to actinic rays by using a liquid developer which comprises
(a) 30 to 80 % by mass of one or more aromatic hydrocarbon compounds having a boiling point of 90 to 300 °C,
characterized in that the developer further comprises
(b) 20 to 70 % by mass of one or more paraffinic and/or naphthenic hydrocarbon compounds having a boiling point of 90 to 300 °C, the sum of the amounts of (a) and (b) being 100 % by mass.

2. The method according to claim 1, wherein the aromatic hydrocarbon compound as the component (a) of the liquid developer has a boiling point of 130 to 200 °C.

3. The method according to claim 1 or 2, wherein the paraffinic hydrocarbon compound of the component (b) of the liquid developer has a boiling point of 150 to 250 °C.

4. The method according to claim 1 or 2, wherein the naphthenic hydrocarbon compound of the component (b) of the liquid developer has a boiling point of 150 to 270 °C.

5. The method according to one of claims 1-4, wherein the liquid developer is or comprises a mixture of 50 to 80 % by mass of component (a) and 20 to 50 % by mass of component (b) .

6. The method according to one of claims 1-5, wherein the liquid developer further contains an alcoholic compound in such an amount that the content thereof is 1 to 30 % by mass, based on the total mass of the liquid developer.

7. The method according to claim 6, wherein the alcoholic compound is selected from n-butanol, n-pentanol, n-hexanol, 3-methyl-3-methoxybutanol and benzyl alcohol.

8. Liquid developer for developing flexographic printing plates having a layer of a photosensitive resin composition exhibiting rubber elasticity on a substrate after pattern-wise exposure of the layer to actinic rays, which comprises
(a) 30 to 80 % by mass of one or more aromatic hydrocarbon compounds having a boiling point of 90 to 300 °C,
characterized in that the developer further comprises
(b) 20 to 70 % by mass of one or more paraffinic and/or naphthenic hydrocarbon compounds having a boiling point of 90 to 300 °C, the sum of the amounts of (a) and (b) being 100 % by mass.

9. Liquid developer according to claim 8,
characterized by one or more of the following features:
- The aromatic hydrocarbon compounds forming the component (a) have a boiling point of 130 to 200 °C;
- the paraffinic hydrocarbon compounds forming the component (b) have a boiling point of 150 to 250 °C;
- the naphthenic hydrocarbon compounds forming the component (b) have a boiling point of 150 to 270 °C;
- the developer is or comprises a mixture of 50 to 80 % by mass of component (a) and 20 to 50 % by mass of component (b);
- the developer further contains an alcoholic compound (c) in such an amount that the content thereof is 1 to 30 % by mass, based on the total amount of (a) and (b).

10. The developer according to claim 9, characterized in that the alcoholic compound (c) is selected from n-butanol, n-pentanol, n-hexanol, 3-methyl-3-methoxybutanol and benzyl alcohol.

## Patentansprüche

1. Verfahren zur Entwicklung von Flexodruckplatten, die eine Schicht aus einer lichtempfindlichen Harzzusammensetzung mit Kautschukelastizität auf einem Substrat aufweisen, nach bildmustergemäßer Belichtung der Schicht mit aktinischer Strahlung unter Verwendung eines flüssigen Entwicklers, der
(a) 30 bis 80 Masse-% einer oder mehrerer aromatischer Kohlenwasserstoffverbindungen mit einem Siedepunkt von 90 bis 300 °C enthält,
dadurch gekennzeichnet, dass der Entwickler ferner
(b) 20 bis 70 Masse-% einer oder mehrerer paraffinischer und/oder naphthenischer Kohlenwasserstoffverbindungen mit einem Siedepunkt von 90 bis 300 °C enthält, wobei die Summe der Mengenanteile (a) und (b) gleich 100 Masse-% ist.

2. Verfahren nach Anspruch 1, wobei die aromatische Kohlenwasserstoffverbindung der Komponente (a) des flüssigen Entwicklers einen Siedepunkt von 130 bis 200 °C aufweist.

3. Verfahren nach Anspruch 1 oder 2, wobei die paraffinische Kohlenwasserstoffverbindung der Komponente (b) des flüssigen Entwicklers einen Siedepunkt von 150 bis 250 °C aufweist.

4. Verfahren nach Anspruch 1 oder 2, wobei die naphthenische Kohlenwasserstoffverbindung der Komponente (b) des flüssigen Entwicklers einen Siedepunkt von 150 bis 270 °C aufweist.

5. Verfahren nach einem der Ansprüche 1 bis 4, wobei der flüssige Entwickler ein Gemisch von 50 bis 80 Masse-% Komponente (a) und 20 bis 50 Masse-% Komponente (b) darstellt oder enthält.

6. Verfahren nach einem der Ansprüche 1 bis 5, wobei der flüssige Entwickler ferner eine alkoholische Verbindung in einer solchen Menge enthält, dass ihr Mengenanteil 1 bis 30 Masse-% beträgt, bezogen auf die Gesamtmasse des flüssigen Entwicklers.

7. Verfahren nach Anspruch 6, wobei die alkoholische Verbindung unter n-Butanol, n-Pentanol, n-Hexanol, 3-Methyl-3-methoxybutanol und Benzylalkohol ausgewählt ist.

8. Flüssiger Entwickler zur Entwicklung von Flexodruckplatten, die eine Schicht aus einer lichtempfindlichen Harzzusammensetzung mit Kautschukelastizität auf einem Substrat aufweisen, nach bildmustergemäßer Belichtung der Schicht mit aktinischer Strahlung, der
(a) 30 bis 80 Masse-% einer oder mehrerer aromatischer Kohlenwasserstoffverbindungen mit einem Siedepunkt von 90 bis 300 °C enthält,
dadurch gekennzeichnet, dass der Entwickler ferner
(b) 20 bis 70 Masse-% einer oder mehrerer paraffinischer und/oder naphthenischer Kohlenwasserstoffverbindungen mit einem Siedepunkt von 90 bis 300 °C enthält, wobei die Summe der Mengenanteile (a) und (b) gleich 100 Masse-% ist.

9. Flüssiger Entwickler nach Anspruch 8, gekennzeichnet durch eines oder mehrere der folgenden Merkmale:
- Die aromatischen Kohlenwasserstoffverbindungen, welche die Komponente (a) bilden, weisen einen Siedepunkt von 130 bis 200 °C auf;
- die paraffinischen Kohlenwasserstoffverbindungen, welche die Komponente (b) bilden, weisen einen Siedepunkt von 150 bis 250 °C auf;
- die naphthenischen Kohlenwasserstoffverbindungen, welche die Komponente (b) bilden, weisen einen Siedepunkt von 150 bis 270 °C auf;
- der Entwickler stellt ein Gemisch von 50 bis 80 Masse-% Komponente (a) und 20 bis 50 Masse-% Komponente (b) dar oder enthält ein solches Gemisch;
- der Entwickler enthält ferner eine alkoholische Verbindung (c) in einer solchen Menge, dass ihr Mengenanteil 1 bis 30 Masse-% beträgt, bezogen auf die Gesamtmenge von (a) und (b).

10. Entwickler nach Anspruch 9, dadurch gekennzeichnet, dass die alkoholische Verbindung (c) unter n-Butanol, n-Pentanol, n-Hexanol, 3-Methyl-3-methoxy-butanol und Benzylalkohol ausgewählt ist.

## Revendications

1. Méthode de développement de plaques d'impression flexographique ayant une couche d'une composition de résine photosensible présentant l'élasticité du caoutchouc sur un substrat après exposition de formation d'un motif de la couche à des rayons actiniques en utilisant un développeur liquide qui comprend
(a) 30 à 80% en masse d'un ou plusieurs composés d'hydrocarbure aromatique ayant un point d'ébullition de 90 à 300°C,
caractérisé en ce que le développeur comprend de plus
(b) 20 à 70% en masse d'un ou plusieurs composés d'hydrocarbure paraffinique et/ou naphténique ayant un point d'ébullition de 90 à 300°C, la somme des quantités de (a) et (b) étant de 100% en masse.

2. Méthode selon la revendication 1, où le composé d'hydrocarbure aromatique en tant que composant (a) du développeur liquide a un point d'ébullition de 130 à 200°C.

3. Méthode selon la revendication 1 ou 2, où le composé d'hydrocarbure paraffinique de composant (b) du développeur liquide a un point d'ébullition de 150 à 250°C.

4. Méthode selon la revendication 1 ou 2, où le composé d'hydrocarbure naphténique du composant (b) du développeur liquide a un point d'ébullition de 150 à 270°C.

5. Méthode selon l'une quelconque des revendications 1-4 où le développeur liquide est ou comprend un mélange de 50 à 80% en masse du composant (a) et de 20 à 50% en masse du composant (b).

6. Méthode selon l'une quelconque des revendications 1-5, où le développeur liquide contient de plus un composé alcoolisé en une quantité telle que sa teneur soit de 1 à 30% en masse en se basant sur la masse totale du développeur liquide.

7. Méthode selon la revendication 6, où le composé alcoolisé est sélectionné parmi n-butanol, n-pentanol, n-hexanol, 3-méthyl-3-méthoxybutanol et alcool benzylique.

8. Développeur liquide pour développer des plaques d'impression flexographique ayant une couche d'une composition de résine photosensible présentant l'élasticité du caoutchouc sur un substrat après exposition de formation d'un motif de la couche à des rayons actiniques, qui comprend
(a) 30 à 80% en masse d'un ou plusieurs composés d'hydrocarbure aromatique ayant un point d'ébullition de 90 à 300°C,
caractérisé en ce que le développeur comprend de plus
(b) 20 à 70% en masse d'un ou plusieurs composés d'hydrocarbure paraffinique et/ou naphténique ayant un point d'ébullition de 90 à 300°C, la somme des quantités de (a) et (b) étant de 100% en masse.

9. Développeur liquide selon la revendication 8,
caractérisé par un ou plusieurs des traits suivants:
- Les composés d'hydrocarbure aromatique formant le composant (a) ont un point d'ébullition de 130 à 200°C;
- les composés d'hydrocarbure paraffinique formant le composant (b) ont un point d'ébullition de 150 à 250°C;
- les composés d'hydrocarbure naphténique formant le composant (b) ont un point d'ébullition de 150 à 270°C;
- le développeur est ou comprend un mélange de 50 à 80% en masse du composant (a) et de 20 à 50% en masse du composant (b);
- le développeur contient de plus un composé alcoolisé (c) en une quantité telle que sa teneur soit de 1 à 30% en masse, en se basant sur la quantité totale de (a) et (b) .

10. Développeur selon la revendication 9,
caractérisé en ce que le composé alcoolisé (c) est sélectionné parmi n-butanol, n-pentanol, n-hexanol, 3-méthyl-3-méthoxy-butanol et alcool benzylique.
